## Europäisches Patentamt
## European Patent Office
## Office européen des brevets

(19)

(11) Numéro de publication: **0 308 285**
**A1**

(12)

# DEMANDE DE BREVET EUROPEEN

(21) Numéro de dépôt: **88402149.4**

(22) Date de dépôt: **24.08.88**

(51) Int. Cl.⁴: **H 03 L 7/12**
**H 03 L 7/18**

(30) Priorité: **26.08.87 FR 8711954**

(43) Date de publication de la demande:
**22.03.89 Bulletin 89/12**

(84) Etats contractants désignés:
**BE CH DE ES FR GB IT LI**

(71) Demandeur: **TONNA ELECTRONIQUE**
**36, avenue Hoche B.P. 287**
**F-51060 Reims Cédex (FR)**

(72) Inventeur: **Korahnke, Gérard**
**6, rue des Chardonnerets Ennery**
**F-57640 Vigy (FR)**

**Laurent, Michel**
**6, route de Borny**
**F-57070 Metz (FR)**

(74) Mandataire: **Martin, Jean-Jacques et al**
**Cabinet REGIMBEAU 26, Avenue Kléber**
**F-75116 Paris (FR)**

(54) Dispositif Comportant une boucle à verrouillage de phase.

(57) La présente invention concerne un dispositif comportant une boucle à verrouillage de phase du type comprenant de façon connue en soi un générateur de signal de référence, un oscillateur commandé en tension (504), un comparateur de phase (502) recevant des signaux dérivés du générateur de signal de référence (501) et de l'oscillateur commandé en tension (504), un filtre de boucle (503) attaqué par la sortie du comparateur de phase (502), et des moyens auxiliaires (506, 507), comportant un comparateur à fenêtre (506), qui coopèrent avec le filtre de boucle (503) pour définir la tension de commande appliqué à l'oscillateur (504), caractérisé par le fait qu'il comprend en outre un additionneur (508) à deux entrées et une sortie, dont une première entrée est reliée à la sortie du filtre de boucle (503) et la sortie est reliée à l'entrée de commande de l'oscillateur commandé en tension (504), un générateur de tension variable (507), intégré aux moyens auxiliaires et commandé par le comparateur à fenêtre (506), est relié à la seconde entrée de l'additionneur (508) et dans l'additionneur (508), le coefficient multiplicateur (A1) de la tension (V1) issue du filtre de boucle (503) est inférieur à 1.

FIG. 5

EP 0 308 285 A1

**Description**

### DISPOSITIF COMPORTANT UNE BOUCLE A VERROUILLAGE DE PHASE.

La présente invention concerne le domaine des dispositifs électroniques comportant une boucle à verrouillage de phase.

La présente invention concerne plus précisément la réalisation d'oscillateurs haute fréquence à synthèse directe.

La présente invention s'applique en particulier à toutes les opérations de conversion de fréquence dans les bandes VHF - UHF sans que cette application toutefois puisse être considérée comme limitative.

Dans la conception d'un oscillateur synthétisé couvrante une large bande de fréquences on souhaite généralement avoir une grande pureté spectrale et un temps de réponse rapide. Malheureusement, dans le cas de l'utilisation d'une synthèse directe, il faut établir un compromis entre ces deux grandeurs, l'amélioration de l'une entraînant une dégradation de l'autre.

Les différents dispositifs comportant une boucle à verrouillage de phase, jusqu'ici proposés, ne donnent pas pleinement satisfaction.

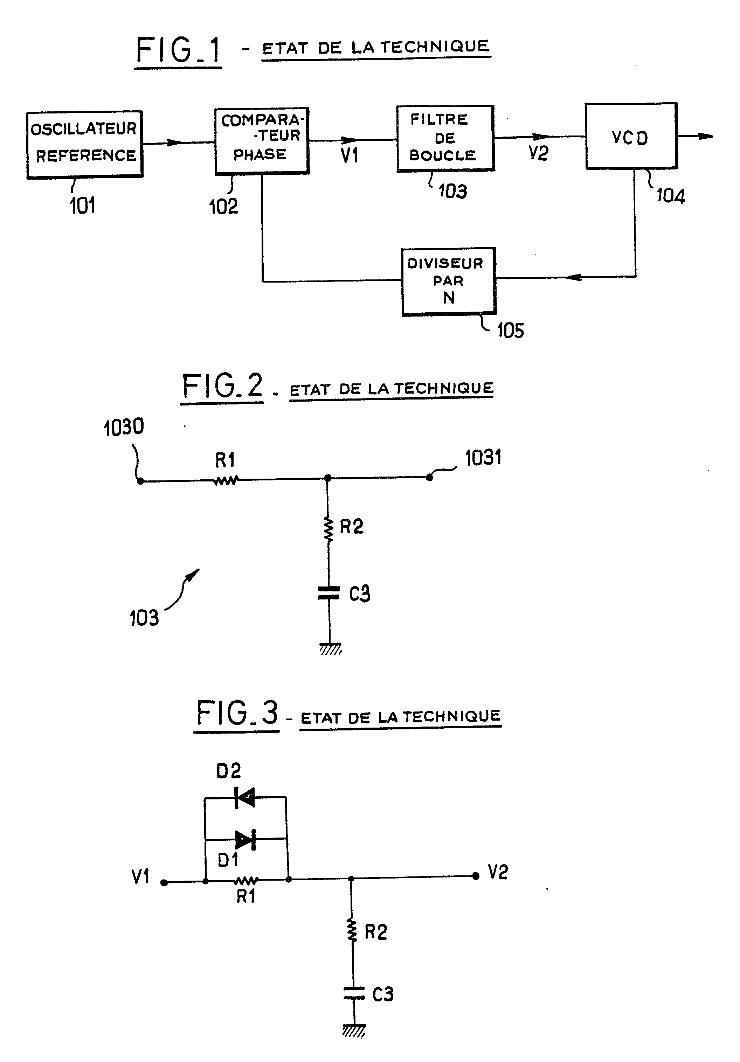

On a représenté sur la figure 1 annexée le synoptique d'une boucle à verrouillage de phase classique.

On distingue sur cette figure 1 un oscillateur de référence 101, un oscillateur commandé en tension 104, un diviseur programmable 105, connecté à la sortie de l'oscillateur commandé en tension, un comparateur de phase 102 recevant les signaux issus de l'oscillateur de référence 101 et du diviseur programmable 105 et un filtre de boucle 103 intercalé entre le comparateur de phase 102 et l'oscillateur commandé en tension 104.

La figure 2 représente une structure de filtre de boucle couramment utilisée dans la conception des synthétiseurs de fréquences.

Une résistance $R_1$ est reliée entre l'entrée 1030 et la sortie 1031 du filtre 103. Une cellule comprenant en série une résistance $R_2$ et un condensateur $C_3$ est reliée entre la sortie 1031 du filtre et la masse du montage.

La fonction de tranfert d'un tel filtre 103 est donnée par la formule :

$$(1) \qquad F(p) = \frac{1 + p\tau_2}{1 + p\tau_1}$$

$$(2) \qquad \tau_2 = R_2 \, C_3$$

$$(3) \qquad \tau_1 = (R_1 + R_2) \, C_3$$

Pour obtenir une bonne pureté spectrale, il faut que la pulsation propre $\omega_n$ de la boucle soit la plus faible possible. L'équation reliant la pulsation propre $\omega_n$ au gain K1 de la boucle et à la constante de temps $\tau_1$ est la suivante :

$$(4) \qquad \omega_n^2 = \frac{K_1}{\tau_1}$$

Le temps de réponse de la boucle est donné par l'équation :

$$(5) \qquad T = \frac{K_2}{\omega_n}$$

où K2 est un coefficient lié à la stabilité de la boucle.

Cette équation (5) montre qu'une diminution de la pulsation propre $\omega_n$ entraîne une augmentation du temps de réponse.

La figure 3 annexée représente une solution connue au problème ainsi posé.

Selon la disposition illustrée sur la figure 3, deux diodes $D_1$, $D_2$ sont montées tête-bêche en parallèle de la résistance $R_1$.

Lorsque la fréquence de l'oscillateur 104 est éloignée de la fréquence programmée par le diviseur 105, la différence de potentiel V2-V1 entre le comparateur de phase 102 et le VCO 104 tend à être importante et l'une des deux diodes D1 et D2 est conductrice. La résistance $R_1$ est court-circuitée. La constante de temps $\tau_1 = (R_1 + R_2)C_3$ devient alors $\tau_1 = R_2 \, C_3$ ce qui entraîne un temps de réponse rapide. Quand la différence de potentiel V2-V1 devient inférieure au seuil des diodes, on se retrouve à nouveau dans le cas d'un filtre tel que celui représenté figure 2.

Si cette solution permet d'améliorer les performances d'une boucle à verrouillage de phase, elle nécessite toutefois l'utilisation d'une capacité C3 de forte valeur et d'une qualité suffisante au niveau des courants de fuite.

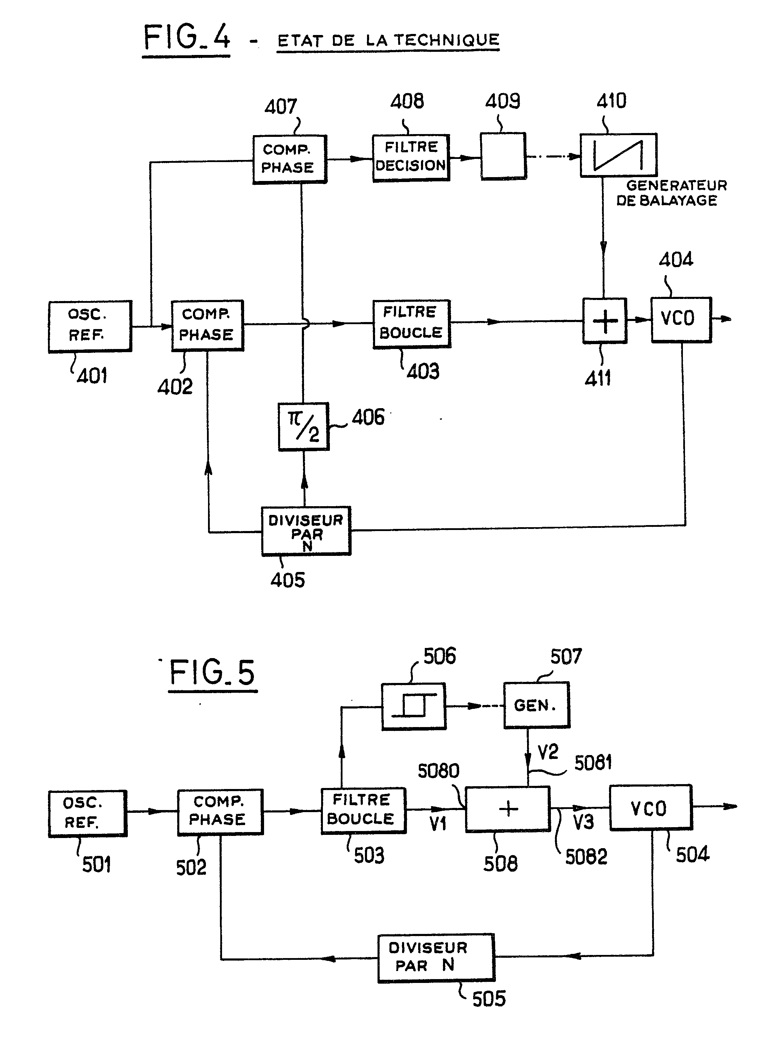

La figure 4 annexée représente une autre solution connue pour réduire le temps de réponse de la boucle en conservant une pulsation propre faible. Cette solution est conforme à l'enseignement du document diffusé par SUPELEC sous la référence 2364 - 1975 -BLANCHARD "Technique des boucles d'asservissement en phase - pages 341-344.

Dans cette solution, on associe à la boucle principale classique illustrée sur la figure 1, une seconde boucle qui comprend un déphaseur de $\pi/2$ 406 relié en sortie du diviseur programmable 405, un comparateur de phase auxiliaire 407 recevant les signaux issus de l'oscillateur de référence 401 et du déphaseur de $\pi/2$ 406, un filtre de décision 408 relié à la sortie du comparateur de phase auxiliaire 407 et qui attaque un comparateur de niveau 409, un générateur de balayage 410 commandé par le comparateur de niveau 409 et un additionneur 411 dont une première entrée est reliée à la sortie du filtre de boucle 403, une seconde entrée est reliée à la sortie du générateur de balayage 410 et la sortie est reliée à entrée de commande de l'oscillateur commandé en tension 404.

Dans ce dispositif, l'association du déphaseur de $\pi/2$ 406 et du comparateur de phase auxiliaire 407 fonctionne comme in détecteur cohérent d'amplitude. Lorsque les signaux issus du VCO 404 et de l'oscillateur de référence 401 sont de fréquences différentes, la tension continue en sortie du comparateur 407 est nulle, le générateur de balayage est alors activé. Sa tension de sortie est ajoutée à la tension issue du filtre de boucle 403, dans l'additionneur 411.

Quand la fréquence du VCO 404 s'approche de la fréquence programmée, une tension continue apparaît en sortie du comparateur de phase 407.

Cette tension mise en forme dans le filtre de décision 408 et le comparateur de niveau 409 fournira la décision d'arrêt du balayage au générateur 410. La tension présente à la sortie du générateur de balayage 410 sera mémorisée et reste additionnée à celle issue du filtre de boucle 403 au niveau de l'additionneur 411. Le fonctionnement sera alors identique à celui d'une boucle classique telle que représentée figure 1.

Dans le cas de la figure 3 on obtient un dispositif permettant de diminuer le temps de réponse T en diminuant momentanément la constante de temps, $\tau1$, sous réserve d'utiliser une capacité C3 de forte valeur et de bonne qualité.

Dans le cas de la figure 4, on diminue le temps de réponse en augmentant artificiellement le gain de la boucle par l'addition d'une tension. Cependant, ce dispositif nécessite un second comparateur de phase et de plus ne conduit pas à une optimalisation du temps de réponse.

Le document US-A-4 562 410 propose une autre boucle à verrouillage de phase qui comprend un oscillateur commandé en tension, un diviseur de fréquence qui reçoit la sortie de l'oscillateur commandé en tension, un générateur de signal de référence, un comparateur de phase qui reçoit le signal de référence et le signal issu du diviseur de fréquence, un filtre de boucle placé entre la sortie du comparateur de phase et l'entrée de commande de l'oscillateur et des moyens auxiliaires aptes à charger ou décharger le condensateur du filtre de boucle en cas d'écart de fréquence trop important. Les moyens auxiliaires comprennent deux comparateurs qui comparent la tension aux bornes du condensateur du filtre de boucle avec des tensions de référence respectives. Ces deux comparateurs forment fonctionnellement un comparateur à fenêtre. Les dispositions décrites dans le document US-A-4 562 410 permettent effectivement d'obtenir un temps de réponse faible. Cependant, le dispositif décrit dans le document US-A-4 562 410 ne donne pas pleinement satisfaction au niveau pureté spectrale.

Le but de l'invention est de proposer un nouveau dispositif permettant de conserver une grande pureté spectrale tout en améliorant le temps de réponse.

Ce but est atteint dans le cadre de la présente invention grâce à un dispositif comportant une boucle à verrouillage de phase du type comprenant de façon connue en soi (par exemple selon le document US-A-4 562 410) :
- un générateur de signal de référence,
- un oscillateur commandé en tension,
- un comparateur de phase recevant des signaux dérivés du générateur de signal de référence et de l'oscillateur commandé en tension,
- un filtre de boucle attaqué par la sortie du comparateur de phase, et
- des moyens auxiliaires, comportant un comparateur à fenêtre, qui coopèrent avec le filtre de boucle pour définir la tension de commande appliqué à l'oscillateur,
caractérisée par le fait que
- il comprend en outre un additionneur à deux entrées et une sortie, dont une première entrée est reliée à la sortie du filtre de boucle et la sortie est reliée à l'entrée de commande de l'oscillateur commandé en tension,
- un générateur de tension variable, intégré aux moyens auxiliaires et commandé par le comparateur à fenêtre, est relié à la seconde entrée de l'additionneur, et
- dans l'additionneur, le coefficient multiplicateur de la tension issue du filtre de boucle est inférieur à 1.

Selon une autre caractéristique avantageuse de la présente invention, l'entrée du comparateur à fenêtre est reliée à la sortie du filtre de boucle.

Selon une autre caractéristique avantageuse de la présente invention, les moyens auxiliaires comprennent un générateur de tension variable dont le niveau peut croître ou décroître en fonction de la sortie du comparateur à fenêtre.

Selon une autre caractéristique avantageuse de la présente invention, le comparateur à fenêtre possède un seuil mini et un seuil maxi et le générateur de tension délivre une tension décroissante lorsque le signal de sortie du filtre de boucle est inférieur au seuil mini, tandis qu'il délivre une tension croissante lorsque le signal de sortie du filtre de boucle est supérieur au seuil maxi.

Par ailleurs de préférence, la tension de sortie du générateur de tension reste constante lorsque le signal de sortie du filtre de boucle est compris entre le seuil mini et le seuil maxi du comparateur à fenêtre.

D'autres caractéristiques, buts et avantages de la présente invention apparaîtront à la lecture de la description détaillée qui va suivre et en regard des dessins annexés, donnés à titre d'exemples non limitatifs, et sur lesquels, les figures 1 à 4 qui illustrent l'état de la technique ayant déjà été décrites :
- la figure 5 représente schématiquement, sous forme de blocs fonctionnels, la structure d'un dispositif conforme à la présente invention, tandis que
- la figure 6 représente un mode de réalisation particulier de ce dispositif.

On aperçoit sur la figure 5 annexée une boucle à verrouillage de phase comprenant de façon classique en soi, et de façon similaire à l'illustration donnée sur la figure 1 précédemment décrite : un oscillateur de référence 501, un comparateur de phase 502, un filtre de boucle 503, un oscillateur commandé en tension 504 et un diviseur programmable 505.

Cependant comme illustré sur la figure 5 selon la présente invention, la boucle à verrouillage de phase comprend en outre une boucle secondaire composée d'un comparateur à fenêtre 506 et d'un générateur de tension 507 qui attaque un additionneur 508 intercalé entre le filtre de boucle 503 et le VCO 504.

l'additionneur 508 possède deux entrées 5080, 5081 et une sortie 5082. Une première entrée 5080 reçoit la tension V1 issue du filtre de boucle 503. La seconde entrée 508 reçoit la tension V2 issue du générateur de tension 507. La sortie 5082 délivre une tension V3 appliquée à l'entrée de commande des VCO 504.

L'entrée du comparateur à fenêtre 506 est reliée à la sortie du filtre de boucle 503. Le comparateur à fenêtre 506 compare ainsi la tension V1 issue du filtre de boucle 503 à un seuil mini d'une part et à un seuil maxi d'autre part. Le seuil mini et le seuil maxi sont de préférence fixes. Cependant, le cas échéant, ils peuvent être définis cas par cas en fonction de la pente du VCO 504 ou tout autre paramètre influent.

Le générateur de tension 507 est adapté pour délivrer une tension variable pilotée par la sortie du comparateur à fenêtre 506.

Plus précisément, le générateur de tension 507 est adapté pour délivrer une tension décroissante lorsque le signal de sortie du filtre de boucle 503 est inférieur au seuil mini, et délivrer une tension croissante lorsque le signal de sortie du filtre de boucle 503 est supérieur au seuil maxi. Par ailleurs, la tension de sortie du générateur de tension 507 reste constante lorsque le signal de sortie du filtre de boucle 503 est compris dans la fenêtre le seuil mini et le seuil maxi du comparateur 506.

La tension V3, issue de l'additionneur 508 et commandant le VCO 504 est donnée par la formula :

$$V3 = V1V1 + A2V2$$

avec A1 < 1,
dans laquelle A1 et A2 représentent les coefficients de multiplication des tensions V1 et V2 dans l'additionneur 508.

Lorsque la fréquence du VCO 404 est éloignée de la fréquence programmée, la tension V1 issue du filtre de boucle 503 se trouve en dehors de la fenêtre définie par le comparateur 506, c'est-à-dire en dessous du seuil mini ou au dessus du seuil maxi, le comparateur à fenêtre 506 commande alors le générateur de tension 507 dans le sens décroissant ou croissant selon le résultant de la comparaison, jusqu'à ce que la tension issue du filtre de boucle 503 soit comprise entre les deux seuils du comparateur à fenêtre 506, la tension V2 issue du générateur 507 est alors mémorisée.

Ce dispositif permet une fois que la fréquence du VCO 504 est proche de la fréquence programmée, de diminuer le gain de la boucle K1 car le coefficient multiplicateur A1 de la tension V1 est inférieur à 1. L'effet des parasites éventuellement présents à la sortie du comparateur de phase est donc réduit. D'après la formule

$$(4)\omega_n^2 = \frac{K1}{\tau_1}$$

Ce dispositif permet de diminuer la pulsation propre $\omega_n$ de la boucle et d'augmenter la pureté spectrale de l'oscillateur synthétisé, tout en conservant la rapidité de réponse grâce au générateur de tension 507.

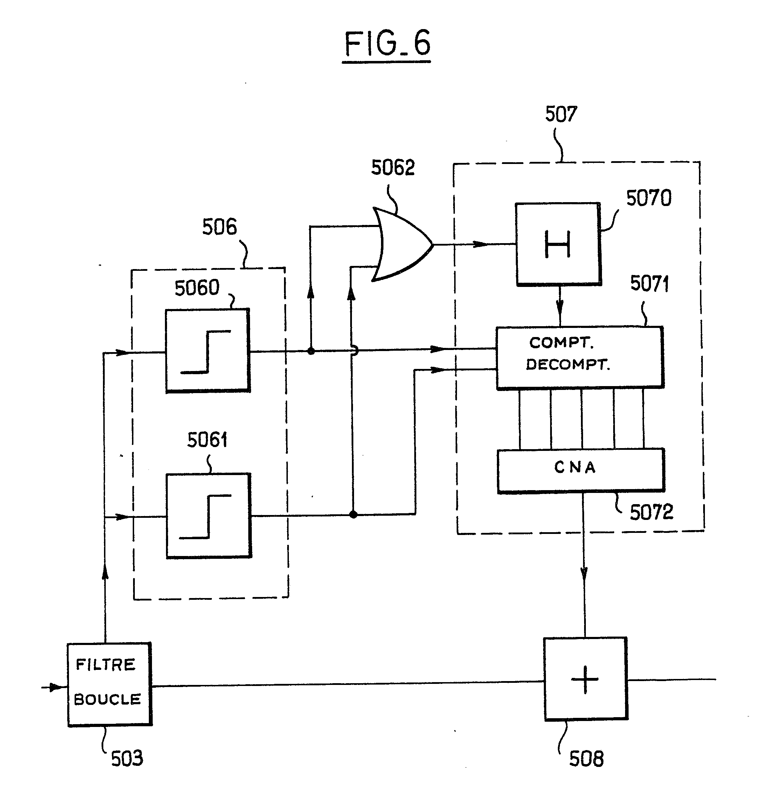

La figure 6 représente un mode de réalisation préférentiel de la boucle secondaire proposée dans le cadre de la présente invention.

On reconnaît sur la figure 6, le filtre de boucle 503, le comparateur à fenêtre 506, le générateur de tension 507 et l'additionneur 508, les autres éléments de la boucle à verrouillage de phase, classiques en soi n'ayant par été représentés pour simplifier l'illustration.

Selon le mode de réalisation illustré sur la figure 6 le générateur de tension 507 est constitué d'une horloge 5070, attaquant un circuit logique compteur/décompteur 5071 suivi d'un convertisseur numérique-analogique 5072.

Le comparateur à fenêtre 506 est formé de deux comparateurs 5060 5061 connectés en parallèle à la sortie du filtre de boucle 503. Les comparateurs 5060, 5061 comparent la tension V1 issue du filtre de boucle 503 à des seuils respectifs haut et bas correspondant l'un au seuil maxi du comparateur à fenêtre 506, l'autre au seuil mini du comparateur à fenêtre 506.

Les sorties des comparateurs 5060 et 5061 sont reliées aux entrées d'une porte logique 5062 dont la sortie attaque une entrée de mise en service de l'horloge 5070.

La porte logique 5062 peut être du type "OU" ou bien "ET" selon la logique des comparateurs 5060, 5061, l'essentiel étant que l'horloge soit activée lorsque la tension V1 issue filtre de boucle 503 est en dehors de la fenêtre définie par le comparateur 506.

Par ailleurs, les sorties des deux comparateurs, haut 5060 et bas 5061, sont reliées respectivement aux entrées de comptage et de décomptage du circuit compteur/décompteur.

Ainsi lorsque la tension à l'entrée du comparateur à fenêtre 506 est située au dessous du seuil du comparateur 5061 l'horloge 5070 est activée via la porte 5062 et le circuit logique 5071 décompte ; la tension V2 appliquée à l'additionneur 508 décroît progressivement.

Inversement lorsque la tension à l'entrée du comparateur à fenêtre 506 est située au dessus du seuil du comparateur 5060, l'horloge 5070 est activée via la porte 5062, mais le circuit logique 5041 compte ; la tension V2 appliquée à l'additionneur 508 croît alors progressivement.

Enfin, lorsque la tension V1 à l'entrée du comparateur à fenêtre 506 est située entre les deux seuils des comparateurs 5060 et 5061, l'horloge 5070 est inhibée et la tension V2 est mémorisée sous forme numérique au niveau du circuit compteur/décompteur 5071.

Le dispositif conforme à la présente invention trouve application dans la conception de dispositifs de traitement de signaux électriques, tels que les dispositifs de transposition de fréquence, les dispositifs de modulation haute fréquence et les dispositifs de réception haute fréquence.

Bien entendu la présente invention n'est pas limitée au mode de réalisation particulier qui vient d'être décrit mais s'étend à toutes variantes conformes à son esprit.

## Revendications

**1.** Dispositif comportant une boucle à verrouillage de phase du type comportant :
- un générateur de signal de référence (501),
- un oscillateur commandé en tension (504),
- un comparateur de phase (502) recevant des signaux dérivés du générateur de signal de référence (501) et de l'oscillateur commandé en tension (504),
- un filtre de boucle (503) attaqué par la sortie du comparateur de phase (502), et
- des moyens auxiliaires (506,507), comportant un comparateur à fenêtre (506), qui coopèrent avec le filtre de boucle (503) pour définir la tension de commande appliqué à l'oscillateur (504),
caractérisé par le fait que
- il comprend en outre un additionneur (508) à deux entrées et une sortie, dont une première entrée est reliée à la sortie du filtre de boucle (503) et la sortie est reliée à l'entrée de commande de l'oscillateur commandé en tension (504),
- un générateur de tension variable (507), intégré aux moyens auxiliaires et commandé par le comparateur à fenêtre (506), est relié à la seconde entrée de l'additionneur (508) et
- dans l'additionneur (508), le coefficient multiplicateur (A1) de la tension (V1) issue du filtre de boucle (503) est inférieur à 1.

**2.** Dispositif selon la revendication 1, caractérisé par le fait que l'entrée du comparateur à fenêtre (506) est reliée à la sortie du filtre de boucle (503).

**3.** Dispositif selon l'une des revendications 1 ou 2, caractérisé par le fait que les moyens auxiliaires comprennent un générateur de tension variable (507) dont le niveau peut croître ou décroître en fonction de la sortie du comparateur à fenêtre (506).

**4.** Dispositif selon la revendication 3, caractérisé par le fait que le comparateur à fenêtre (506) possède un seuil mini et un seuil maxi et le générateur de tension (507) délivre une tension décroissante lorsque le signal de sortie du filtre de boucle (503) est inférieur au seuil mini, tandis qu'il délivre une tension croissante lorsque le signal de sortie du filtre de boucle (503) est supérieur au seuil maxi.

**5.** Dispositif selon la revendication 4, caractérisé par le fait que la tension (507) reste constante lorsque le signal de sortie du filtre de boucle (503) est compris entre le seuil mini et le seuil maxi du comparateur à fenêtre (506).

**6.** Dispositif selon l'une des revendications 1 à 5, caractérisé par le fait que le générateur de tension comprend une horloge (5070), un circuit compteur/décompteur (5071) relié à la sortie de l'horloge (5070) et un convertisseur numérique/analogique (5072) connecté à la sortie du compteur/décompteur.

**7.** Dispositif selon l'une des revendications 1 à 6, caractérisé par le fait que le comparateur à fenêtre (506) comprend deux comparateurs (5060, 5061) connectés en parallèle à la sortie du filtre de boucle (503).

**8.** Dispositif selon les revendications 6 et 7 prises en combinaison, caractérisé par le fait que les sorties des deux comparateurs (5060, 5061) sont reliées aux entrées d'une logique (5062) dont la sortie attaque l'horloge (5070) pour valider celle-ci lorsque le signal de sortie du filtre de boucle (503) n'est pas compris dans la fenêtre du comparateur à fenêtre (506), les sorties des deux comparateurs (5060, 5061) étant par ailleurs reliées respectivement aux entrées de comptage et de décomptage du circuit compteur/décompteur (504).

**9.** Application du dispositif conforme à l'une des revendications 1 à 8 à la réalisation d'un dispositif de traitement de signaux électriques, choisi dans le groupe comprenant les dispositifs de transposition de fréquence, les dispositifs de modulation haute fréquence, et les dispositifs de réception haute fréquence.

## FIG_1 - ETAT DE LA TECHNIQUE

## FIG.2 - ETAT DE LA TECHNIQUE

## FIG_3 - ETAT DE LA TECHNIQUE

## FIG.4 - ETAT DE LA TECHNIQUE

## FIG.5

# FIG_6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | IEEE TRANSACTIONS ON INSTUMENTATION AND MEASUREMENT, vol. IM-31, no. 3, septembre 1982, pages 185-192, IEEE, New York, US; T.L. LANDECKER et al.: "A phase-stabilized local-oscillator system for a synthesis radio telescope" * Page 187, colonne de gauche, ligne 4 - page 188, colonne de gauche, ligne 11; figure 3 * | 1,2,9 | H 03 L 7/12 H 03 L 7/18 |
| Y | IDEM | 3-8 | |
| Y | DE-A-2 626 290 (TELEFONAKTIEBOLAGET LM ERICSSON) * Page 3, ligne 12 - page 6, ligne 6; figure * | 3-8 | |
| Y | US-A-4 562 410 (O'ROURKE) * Colonne 5, ligne 66 - colonne 8, ligne 49; figure 2 * | 3-5,7 | |
| A | PATENT ABSTRACTS OF JAPAN, vol. 3, no. 52(E-108), 7 mai 1979, page 105 E 108; & JP-A-54 31 257 (HITACHI DENSHI K.K.) 03-08-1979 * Résumé * | 5,6 | **DOMAINES TECHNIQUES RECHERCHES (Int. Cl.4)** H 03 L |

**Le présent rapport a été établi pour toutes les revendications**

| Lieu de la recherche | Date d'achèvement de la recherche | Examinateur |
|---|---|---|
| LA HAYE | 25-11-1988 | BALBINOT H. |

EPO FORM 1503 03.82 (P0402)